# EUROPEAN PATENT SPECIFICATION

(11) **EP 1 238 948 B1**
(45) Date of publication and mention of the grant of the patent: **25.01.2006**
(21) Application number: 02008475.2
(22) Date of filing: 12.08.1997
(51) Int. Cl.: C03C 17/00, C03C 17/245, C23C 16/40

(54) **Method of depositing tin oxide coatings on flat glass and the resulting coated glass**
Verfahren zur Abscheidung von Beschichtungen aus Zinnoxid auf Flachglas und so beschichtetes Glas
Procédé servant à déposer de l'oxyde d'étain sur verre plat et verre revêtu au moyen de ce procédé

(30) Priority: 13.08.1996 GB 9616983
(43) Date of publication of application: 11.09.2002
(62) Divisional of application: 97936780.2
(73) Proprietor: PILKINGTON PLC, St. Helens, Merseyside WA10 3TT (GB); Pilkington North America, Inc., as Libbey-Owens-Ford Co, Toledo, Ohio 43695 (US)
(72) Inventor: Sheel, David, William, Aughton, Lancashire L39 5EB (GB); McCurdy, Richard, J., Toledo, OH 43606 (US); Hurst, Simon, James, Sandymoor, Runcorn, Cheshire WA7 1QW (GB)
(74) Representative: Halliwell, Anthony Charles

(56) References cited:
- EP-A- 0 186 481
- GB-A- 2 044 137
- US-A- 4 731 256
- US-A- 5 124 180
- US-A- 5 401 305
- DATABASE WPI Section Ch, Week 9717 Derwent Publications Ltd., London, GB; Class L01, AN 97-180109 XP002047099 & CN 1 093 067 A (UNIV SHANDONG), 5 October 1994 (1994-10-05)

## Description

### BACKGROUND OF THE INVENTION

### 1. Field of the Invention

This invention relates to a process for depositing tin oxide coatings on a flat glass substrate, and the resulting coated glass. More particularly, this invention relates to a chemical vapour deposition process for producing tin oxide coatings on flat glass using a coating precursor gas mixture comprising tin tetrachloride and an organic oxidant.

### 2. Summary of Related Art

Tin oxide coatings have been proposed for use on glass containers, for example bottles, to improve the mechanical strength of the containers. It has also been proposed to use tin oxide coatings on flat glass to modify the characteristics of the glass for architectural use; tin oxide coatings are used, not only as layers of multi-layer sputtered coatings, but also deposited pyrolytically with a dopant as infra red reflecting and/or electroconducting coatings.

GB patent specification 1 115 342 describes a process for producing glass containers with good inherent strength and good abrasion resistance by spraying the containers, while still hot from the manufacturing process, with a solution or dispersion of stannic chloride (that is, tin tetrachloride) in an organic liquid, isopropyl alcohol being preferred. A small amount of titanium chloride may be incorporated as a modifier. The liquid solution is fed to atomisers, which may be of the pressure jet variety, located on either side of a tunnel over a conveyor for hot glass bottles to produce a mist of liquid reagent' so that a layer of liquid is formed on all the external surfaces of the bottles where it reacts to form a layer of tin oxide.

GB patent specification 1 187 784 describes an improvement of the process described in GB patent specification 1 115 342 and apparently more suitable for incorporation into a process for the automatic manufacture of glassware without interfering with the normal running of such process and without requiring additional supervision. The specification proposes to treat glass containers, at high temperature, with a liquid solution of an organic compound of tin "which compound has properties such that upon application of heat it decomposes into two materials, one of which is an organic compound of tin of high decomposition temperature which reacts with the glass surface to produce a diffusion layer of tin oxide within the glass surface, while the other is a volatile compound of tin such that a substantial proportion of vapour of said compound is produced, and subjecting the containers to a heat treatment such that a reaction is caused to occur between the glass at at least the surfaces of the containers and the tin compounds". The material used for treating the glass containers may be provided by reacting tin tetrachloride with organic substances containing carbonyl groups of moderate activity e.g. organic esters of ethyl, n-propyl, isopropyl, n-butyl and isobutyl alcohols with acetic, propionic and butyric acids. The resulting solution may be sprayed, in the presence of ambient atmosphere, on to the hot containers e.g. in the form of a fine mist after they leave the forming machine and before they enter the annealing lehr.

It has also been proposed to use tin tetrachloride, applied either as a liquid spray or, more recently, in gaseous form, to apply a tin oxide coating to hot flat glass to form an electroconductive, infra-red reflecting coating on the hot glass surface; water is used to hydrolyse the tin tetrachloride and as a source of oxygen for formation of the tin oxide.

Processes involving use of the reactants in gaseous form (also called CVD or chemical vapour deposition processes) have certain advantages over spray processes for coating flat glass, especially when the reactants can be premixed before application to the glass. Unfortunately, tin tetrachloride reacts readily with water so that previous proposals to use tin tetrachloride and water vapour in gaseous form have usually involved supplying the gases separately to the glass surface and mixing them while in contact with the glass.

GB patent specification 2 044 137A relates to such a process in which discrete laminar streams of each reactant are formed and projected on to a hot glass substrate by bringing the streams together in reciprocal tangential contact over the glass. The patent also suggests supplying hydrogen to one of the gas streams to attenuate the violent reaction between the tin tetrachloride and the water vapour. This may be done either by direct addition of gaseous hydrogen, or by the addition of methanol, which is said to react in situ to produce the desired gaseous hydrogen.

GB patent specification 2 026 454B describes a process in which a coating chamber is positioned over a hot float glass ribbon as it advances from the float bath and successive gaseous streams of (1) preheated nitrogen carrier gas, (2) tin tetrachloride entrained in preheated nitrogen and (3) air, water vapour and hydrofluoric acid are introduced into the coating chamber so they flow along the glass substrate surface being coated as a substantially turbulence free layer. The patent specifies the concentration of water vapour and tin tetrachloride in the gaseous medium over the glass.

European patent specifications 0 365 239B1 and 0 376 240B1 describe a method and apparatus for depositing a tin oxide coating on a hot glass ribbon. A first gaseous stream of tin tetrachloride in preheated dry air is caused to flow along the surface of the hot ribbon of glass advancing beneath a coating chamber, a second turbulent stream of hydrofluoric acid and steam introduced into the coating chambers at right angles to the plane of the glass and direction of flow of the first gaseous stream, and the combined first and second gas streams drawn through the coating chamber over the glass under turbulent flow conditions.

US patent 4 590 096 describes a process in which a coating solution comprising a substantially solvent free mixture of an organotin chloride and a reactive organic fluorine compound soluble in or miscible with the organotin chloride is introduced to a preheated carrier gas stream which contains sufficient water vapour that the relative humidity of the gas stream at 18°C is about 6% to about 100%. The resulting gas stream is passed over a hot glass surface to deposit a fluorine doped tin oxide coating on the hot glass. A wide range of organotin compounds may be used, and the possibility of using tin tetrachloride is mentioned. Similarly, a wide range of organic fluorine compounds, including oxygen containing compounds, for example trifluoroacetic acid and ethyltrifluoroacetate, may be used. Some of the fluorine-containing dopants have limited solubilities in the organotin compounds used, and an optional solubiliser may be used to increase the solubility of the fluorine dopant on the organotin compound; acetic anhydride, ethyl acetate, hexane, methyl isobutyl ketone and butyraldehyde are listed as non-limiting examples of the solubilisers that may be used. However, the US patent, in common with the other patents utilising chemical vapour deposition methods to deposit a metal oxide from a gaseous metal tetrachloride, utilises water vapour as the source of oxygen.

US patent 4 751 149 Vijaykumar et al is concerned with deposition of zinc oxide coatings by chemical vapour deposition at low temperature (60° to 350°C, preferably 100° to 200°C) on heat sensitive photoconductor substrates, and proposes to deposit the zinc oxide coatings from an organozinc compound and an oxidant, which may be an oxygen containing organic compound e.g. an ester, and an inert carrier gas. Although the patent is not entirely clear, it apparently proposes to introduce separate streams of the organozinc compound and oxidant into the deposition chamber, and certainly there is no proposal to pre-mix these components together before delivery to the coating chamber.

US patent 4 731 256 and European patent 0186 481 processes for the production of fluorine doped tin oxide coatings using a liquid coating composition comprising a reactive fluorine dopant and an organotin compound. US 5 401 305 discloses a process for depositing a coating on a glass substrate by contacting it with a gaseous mixture comprising a precursor for a metal oxide a precursor for silicon dioxide and an accelerant. US 5 124 180 discloses processes for depositing a fluorinated tin oxide coating using tin tetrachloride and a dopant having a vinylic fluorine atom. GB 2 044 137 and CN1093067 disclose deposition processes in which the reactants are not premixed but are fed separately to the surface which is to be coated .

It would be advantageous to provide a method for depositing tin oxide coatings by a CVD process applied to hot flat glass using a premixture of tin tetrachloride as a low cost reactant and a source of oxygen without premature reaction between the tin tetrachloride and oxygen source (previously water) resulting in formation of tin oxide in the coating equipment with consequent problems and inefficiency. It would be particularly advantageous if the method allowed for deposition of the coating at high rates, enabling a required coating thickness to be deposited on a moving glass ribbon during the glass production process.

### SUMMARY OF THE INVENTION

In accordance with the present invention, there is provided a chemical vapour deposition process for laying down a tin oxide coating on a hot glass substrate using a precursor gas mixture containing tin tetrachloride and an organic source of oxygen, without the requirement for inclusion of water vapour and the consequent risk of premature reaction.

The present invention provides a process for depositing a tin oxide coating on hot flat glass comprising the steps of
(a) preparing a precursor gas mixture containing tin tetrachloride and an organic oxygen containing compound as a source of oxygen for formation of the tin oxide,
(b) maintaining said precursor gas mixture at a temperature below the temperature at which the tin tetrachloride reacts to form the tin oxide while delivering the mixture to a coating chamber opening on to the hot glass,
(c) introducing the precursor gas mixture into the coating chamber whereby the mixture is heated to cause deposition of tin oxide incorporating oxygen from the organic compound on to the hot glass surface.

Surprisingly, a wide range of oxygen-containing organic compounds may be used as the source of oxygen, without requiring the presence of water vapour or gaseous oxygen, including compounds normally considered reducing agents rather than oxidising agents, for example, alcohols. However, the preferred organic compounds are carbonyl compounds, especially esters; and particularly good results have been obtained using esters having an alkyl group with a β hydrogen. The alkyl group with a β hydrogen will normally contain two to ten carbon atoms.

It is preferred to use organic compounds, especially esters, containing from two to ten carbon atoms, since larger molecules tend to be less volatile and hence less convenient for use in the CVD process of the present invention.

Particularly preferred esters for use in the practice of the present invention include ethyl formate, ethyl acetate, ethyl propionate, isopropyl formate, isopropyl acetate, n-butyl acetate and t-butyl acetate.

The method of the present invention is generally practised in connection with the formation of a continuous glass ribbon substrate, for example during a float glass production process. However, the method of the present invention may be employed in coating other flat glass substrates either on-line or off-line.

The present invention involves the preparation of a precursor gas mixture which includes tin tetrachloride and an organic oxygen containing compound; a carrier gas or diluent, for example, nitrogen, air or helium, will normally also be included in the gas mixture. Since thermal decomposition of the organic oxygen containing compound may initiate the tin oxide deposition reaction at a high rate, it is desirable that the precursor mixture be kept at a temperature below the thermal decomposition temperature of the organic oxygen compound to prevent prereaction of the gaseous mixture with formation of the tin oxide.

The gaseous mixture is maintained at a temperature below that at which it reacts to form the tin oxide, and delivered to a location near a flat glass substrate to be coated, the substrate being at a temperature above said reaction temperature (and above the decomposition temperature of the organic oxygen compound in the precursor gas mixture).

The precursor gas mixture is thereafter introduced into the vapour space directly over the substrate. The heat from the substrate raises the temperature of the precursor gas above the thermal decomposition temperature of the organic oxygen compound. The organic oxygen compound then decomposes with reaction with the tin tetrachloride producing a tin oxide coating on the substrate.

The present invention permits the production of tin oxide coatings deposited on the hot glass at a high deposition rate e.g. over 13nm/second (130Å/second) and, in preferred embodiments, over 25nm/second (250Å/second).

The deposition rate is dependent upon the particular organic oxygen containing compound used, and the concentrations of both the organic oxygen containing compound and the tin tetrachloride, as well as the temperature of the glass. For any particular combination of compounds, the optimum concentrations (and in particular the optimum proportion of organic oxygen containing compound to tin tetrachloride) and flow rates for rapid coating deposition may be determined by simple trial. However, it will be appreciated that the use of higher concentrations of reactants and high gas flow rates is likely to result in a less efficient overall conversion of the reactants into coating, so that the optimum condition for commercial operation may differ from the conditions which provide the highest deposition rates.

Preferably, the organic oxygen containing compound will be at a concentration by volume of about 0.5, especially 1, to 5 times the concentration by volume of the tin tetrachloride. It will commonly be used in an amount of at least 30% by weight of the weight of tin tetrachloride.

The method of the invention permits the production, at high rates, of tin oxide coatings on hot flat glass substrates on line during the glass production process. The tin oxide coatings may be doped, for example with fluorine, by incorporating an appropriate precursor for the dopant into the precursor gas mixture, increasing the electrical conductivity and infra red reflectivity of the coatings, and hence their utility as electrical conducting coatings and/or low emissivity coatings in architectural glazing and other applications.

### BRIEF DESCRIPTION OF THE DRAWINGS

The above, as well as other advantages of the present invention, will become readily apparent to those skilled in the art from the following detailed description of preferred embodiments when considered in the light of the accompanying drawings in which:
Fig 1 is a schematic view of a vertical section of an apparatus for practising a float glass process which includes gas distributors suitably positioned to enable the practising of the method of the present invention.
Fig 2 is broken sectional view of an article coated according to this invention; and
Fig 3 is an enlarged schematic end view of a gas distributor beam suitable for use in practising the present invention.
Fig 4 is an enlarged schematic end view of an alternative gas distributor beam which may be used in practising the present invention.

### DESCRIPTION OF THE PREFERRED EMBODIMENT

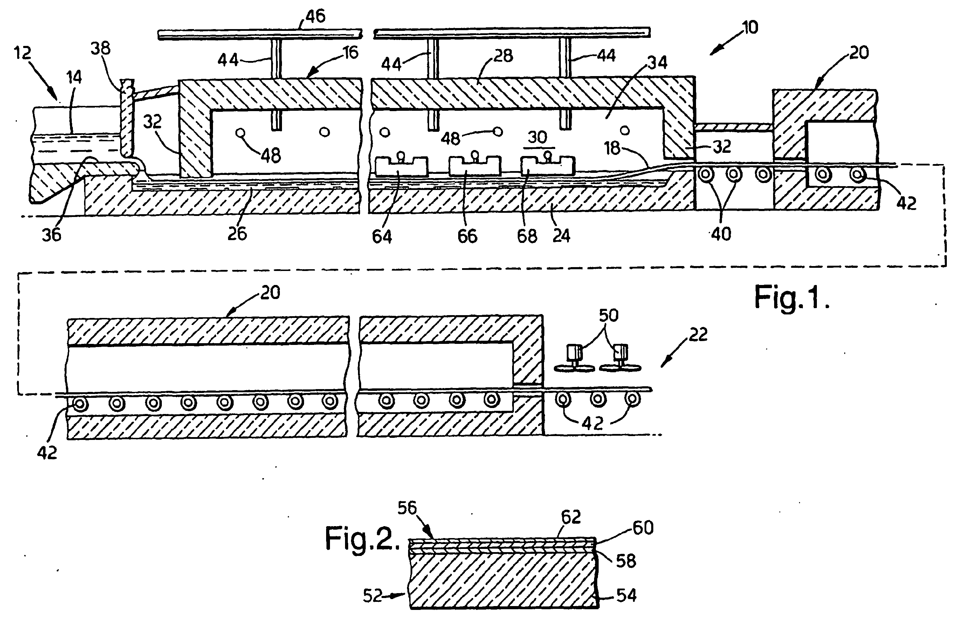

Referring now more particularly to the drawings, there is illustrated generally at 10 in Fig 1 a float glass installation utilized as a means for practising the method of the present invention. The float glass apparatus more particularly comprises a canal section 12 along which molten glass 14 is delivered from a melting furnace (not shown), to a float bath section 16 wherein a continuous glass ribbon 18 is formed in accordance with the well known float process. The glass ribbon 18 advances from the bath section 16 through an adjacent annealing lehr 20 and a cooling section 22. The continuous glass ribbon 18 serves as the substrate upon which the tin oxide coating is deposited in accordance with the present invention.

The float section 16 includes a bottom section 24 within which a bath of molten tin 26 is contained, a roof 28, opposite sidewalls 30, and end walls 32. The roof 28, side walls 30, and end walls 32 together define an enclosure 34 in which a non-oxidizing atmosphere is maintained to prevent oxidation of the molten tin.

Additionally, gas distributor beams 64, 66 and 68 are located in the bath section 16. The gas distributor beams 64 and 66 in the bath section may be employed to apply additional coatings onto the substrate prior to applying the tin oxide coating by the method of the present invention. The additional coatings may include silicon and silica.

In operation, the molten glass 14 flows along the canal 36 beneath a regulating tweel 38 and downwardly onto the surface of the tin bath 26 in controlled amounts. On the tin bath the molten glass spreads laterally under the influences of gravity and surface tension, as well as certain mechanical influences, and it is advanced across the bath to form the ribbon 18. The ribbon is removed over lift out rolls 40 and is thereafter conveyed through the annealing lehr 20 and the cooling section 22 on aligned rolls 42. The application of the coating of the present invention may take place in the float bath section 16, or further along the production line, for example in the gap between the float bath and the annealing lehr, or in the annealing lehr.

A suitable non-oxidizing atmosphere, generally nitrogen or a mixture of nitrogen and hydrogen in which nitrogen predominates, is maintained in the bath enclosure 34 to prevent oxidation of the tin bath. The atmosphere gas is admitted through conduits 44 operably coupled to a distribution manifold 46. The non-oxidizing gas is introduced at a rate sufficient to compensate for normal losses and maintain a slight positive pressure, on the order of about 100 to about 1000 Pa (about 0.001 to about 0.01 atmosphere) above ambient atmospheric pressure, so as to prevent infiltration of outside atmosphere. Heat for maintaining the desired temperature regime in the tin bath 26 and the enclosure 34 is provided by radiant heaters 48 within the enclosure. The atmosphere within the lehr 20 is typically atmospheric air, while the cooling section 22 is not enclosed and the glass ribbon is open to the ambient atmosphere. Ambient air may be directed against the glass ribbon as by fans 50 in the cooling section. Heaters (not shown) may also be provided within the annealing lehr for causing the temperature of the glass ribbon to be gradually reduced in accordance with a predetermined regime as it is conveyed therethrough.

Fig 1 illustrates the use of gas distributor beams 64, 66 and 68 positioned in the float bath 16 to deposit the various coatings on the glass ribbon substrate. The gas distributor beam is one form of reactor that can be employed in practising the process of the present invention.

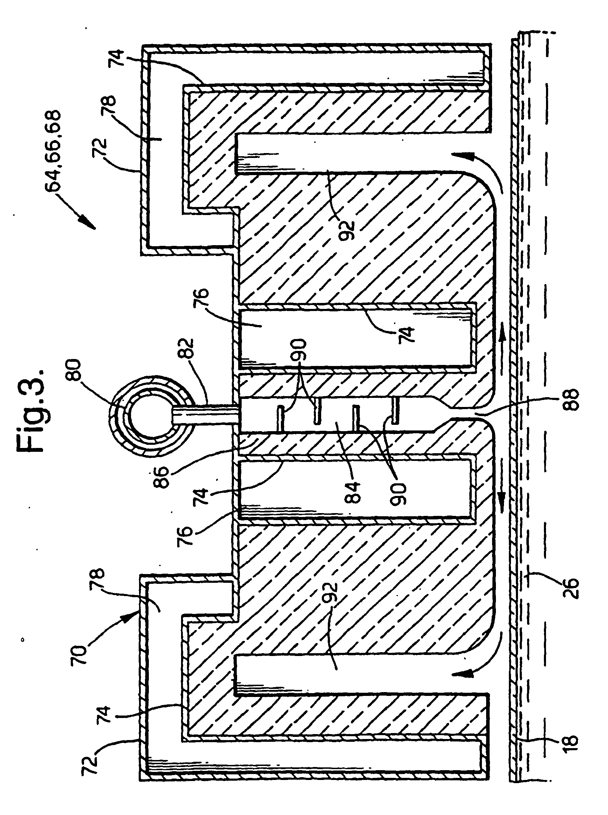

A convenient configuration for the distributor beams suitable for supplying the precursor materials in accordance with the invention is shown generally schematically at Fig 3. An inverted generally channel-shaped framework 70 formed by spaced inner and outer walls 72 and 74 defines enclosed cavities 76 and 78. A suitable heat exchange medium is circulated through the enclosed cavities 76, 78 in order to maintain the distributor beams at a desired temperature.

The precursor gas mixture is supplied through a fluid cooled supply conduit 80. The supply conduit 80 extends along the distributor beam and admits the gas through drop lines 82 spaced along the supply conduit. The supply conduit 80 leads to a delivery chamber 84 within a header 86 carried by the framework. Precursor gases admitted through the drop lines 82 are discharged from the delivery chamber 84 through a passageway 88 toward a coating chamber defining a vapour space opening on to the glass where they flow along the surface of the glass 18 in the direction of the arrows in Fig 3.

Baffle plates 90 may be provided within the delivery chamber 84 for equalizing the flow of precursor materials across the distributor beam to assure that the materials are discharged against the glass 18 in a smooth, laminar, uniform flow entirely across the distributor beam. Spent precursor materials are collected and removed through exhaust chambers 92 along the sides of the distributor beam.

Various forms of distributor beams used for chemical vapour deposition are suitable for the present method and are known in the prior art.

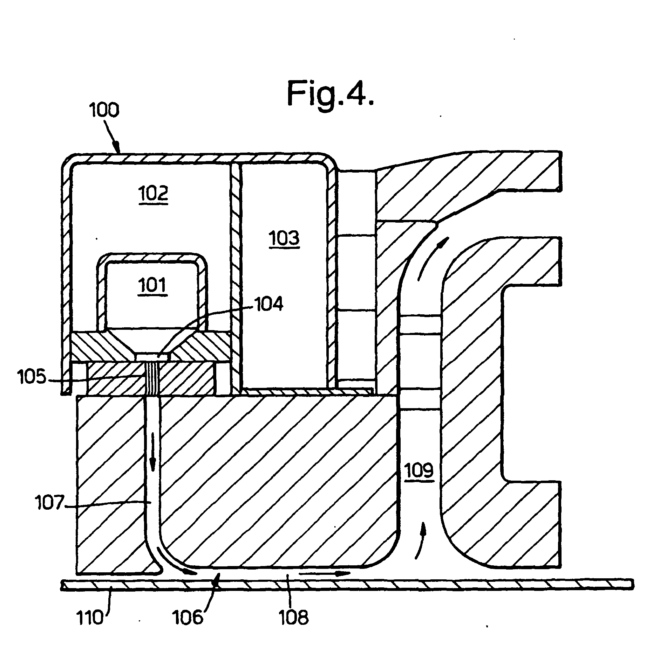

One such an alternative distributor beam configuration is illustrated schematically in Figure 4 of the drawings. Using this distributor, which is generally designated 100 (and more fully described in European patent EP 0 305 102B), the precursor gas mixture is introduced through a gas supply duct 101 where it is cooled by cooling fluid circulated through ducts 102 and 103. Gas supply duct 101 opens through an elongated aperture 104 into a gas flow restrictor 105.

Gas flow restrictor 105 is of the kind more fully described in UK patent specifications GB 1 507 996, and comprises a plurality of metal strips longitudinally crimped in the form of a sine wave and vertically mounted in abutting relationship with one another extending along the length of the distributor. Adjacent crimped metal strips are arranged "out of phase" to define a plurality of vertical channels between them. These vertical channels are of small cross-sectional area relative to the cross-sectional area of gas supply duct 101, so that the gas is released from the gas flow restrictor 105 at substantially constant pressure along the length of the distributor.

The coating gas is released from the gas flow restrictor into the inlet side 107 of a substantially U-shaped guide channel generally designated 106 comprising inlet leg 107, coating chamber 108 which opens onto the hot glass substrate 110 to be coated, and exhaust leg 109, whereby used coating gas is withdrawn from the glass. The rounded corners of the blocks defining the coating channel promote a uniform laminar flow of coating parallel to the glass surface across the glass surface to be coated.

The following examples (in which gas volumes are expressed under standard conditions, i.e. one atmosphere pressure and ambient temperature, unless otherwise stated) are presented for the purpose of further illustrating and disclosing the present invention, and are not to be construed as a limitation on the invention:

### Examples 1-6

In this series of Examples, a static coater was used in the laboratory to apply a tin oxide coating on to a float glass substrate carrying a colour suppressing silicon oxide layer produced as described in European patent EP 0 275 662B.

The float glass to be coated was supported on a nickel block in a reactor vessel and the block heated from below by electric heating elements to provide a glass temperature of 585°C (1085°F). A flat graphite plate was mounted approximately 0.4 inches/10 mm above the glass and parallel thereto to provide a gas flow path 0.4 inches/10 mm deep between the glass surface bearing the silicon oxide layer and the plate.

A precursor gas mixture containing tin tetrachloride and an organic source of oxygen, air and a small proportion of additional nitrogen as carrier gas, was delivered through a gas line maintained at a temperature of 225°C ± 15°C (435°F ± 25°F) and provided with a fish tail nozzle opening on to the gas flow path over the hot glass in a general direction parallel to the glass surface. The total carrier gas flow rate was 13 m³/hour. The flow rates of the tin tetrachloride, and the nature and flow rates of the organic compound used, were as shown in the accompanying Table 1. In Examples 2 and 4, small amounts of 40% hydrogen fluoride were incorporated in the precursor gas mixture to dope the resulting tin oxide coating with fluorine, as shown in the Table.

The gas flow containing the reactant gases was applied for approximately 8 seconds, and the coating apparatus and coated glass then allowed to cool under a flow of air at 225°C (345°F). On dismantling the coating apparatus, the delivery gas line, nozzle and plate defining the gas flow path over the glass found to be free, in each case, from deposit, indicating an absence of undesirable prereaction. In each case, the glass had a tin oxide coating applied over the silicon oxide, the thickness of the coating varying with distance from the fishtail nozzle. The maximum thickness and corresponding growth rate for each precursor gas mixture used is shown in Table 1. The emissivity, resistivity and haze of the samples producing using hydrogen fluoride to incorporate a fluorine dopant (Examples 2 and 4) were measured and the results reported in Table 1.

This series of Examples shows that an organic source of oxygen can be used as part of a premixed precursor gas mixture comprising tin tetrachloride to deposit a tin oxide coating without significant undesirable prereaction detrimentally affecting the coating process e.g. by deposition of tin oxide in the gas supply ducts. Moreover, if desired, a source of dopant, such as hydrogen fluoride, may be incorporated in the gaseous premixture to reduce the emissivity and resistivity of the coating while continuing to avoid significant detrimental prereaction.

### Example [7]

In this Example, a coating distributor as illustrated schematically in Figure 4 was used in a float bath to apply a coating of tin oxide by a method in accordance with the invention. The ribbon speed was approximately 350 meters per hour (233 inches per minute) and the glass thickness was 1.2 mm (0.05 inches). The glass temperature was approximately 630°C (1170°F). The temperature of the gas supply duct 101 which served as a primary gas mixing chamber was maintained at 150°C (300°F) and the 'static' waffle gas distributor 105 was approximately 340°C (645°F). The tin tetrachloride and butyl acetate vapours were delivered by bubbling nitrogen through the liquids maintained at 80°C (175°C) in bubblers and, hence, through separate heated conduits to gas supply duct 101. The vapours mixed at the primary chamber, passed through the waffle pack gas distributor, and then under laminar

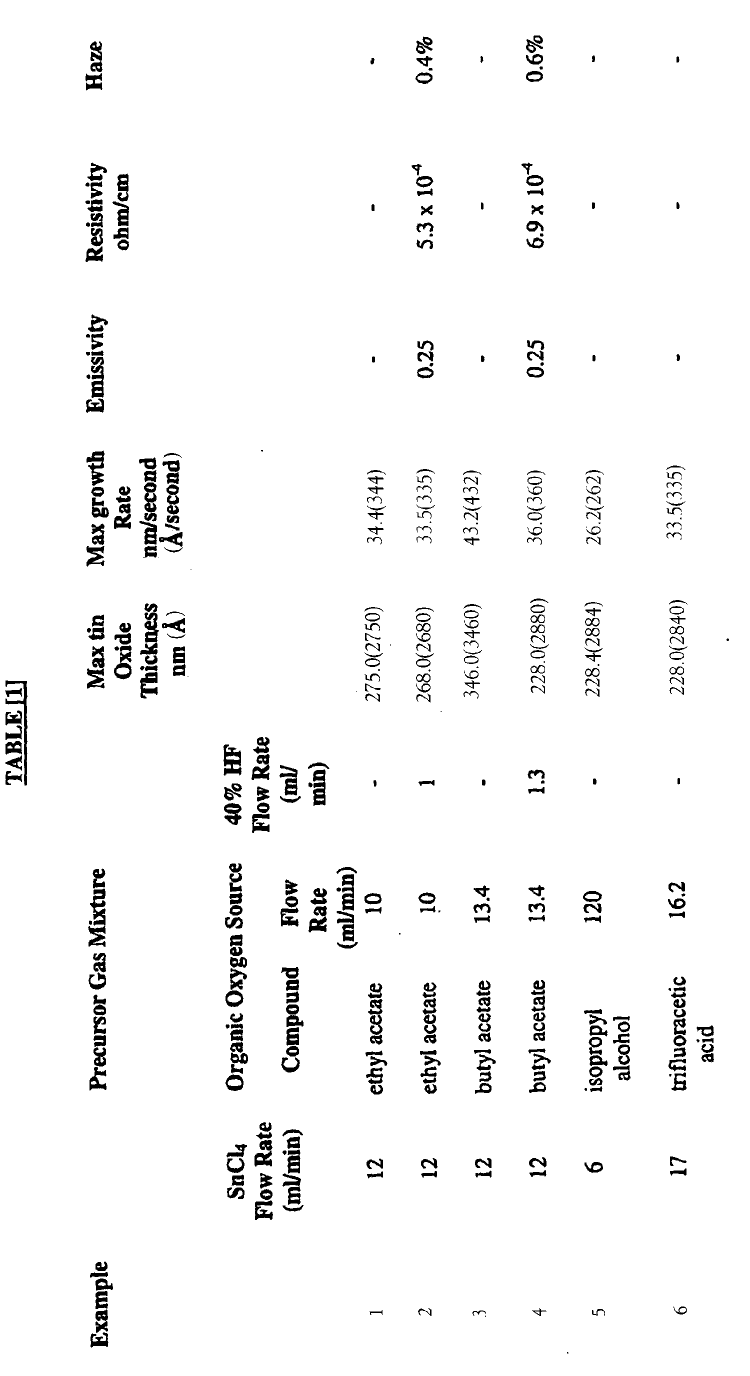

flow conditions through U-shaped guide channel 106 comprising coating chamber 108 opening on to the hot glass ribbon.

The flow rates used were sufficient to obtain tin tetrachloride : butyl acetate molar ratios of between 1: 1 and 1 : 5. The trial was carried out for 5 hours. On dismantling the coater it was discovered that the cooled surfaces and the associated conduits were over 90% free of deposits, thus showing that tin tetrachloride and butyl acetate used for producing a tin dioxide coating on glass can be premixed with one another without substantial prereaction. A thin tin oxide coating was obtained on the glass ribbon.

It will be appreciated that various changes and modifications can be made from the specific details of the invention as incorporated in the foregoing Examples without departing from the scope thereof as defined in the appended claims. In its essential details, the invention is a continuous chemical vapor deposition process for laying down tin oxide coatings onto a glass substrate at high deposition rates through the use of tin tetrachloride and an organic compound used as a source of oxygen in a preformed precursor gas mixture.

Tin tetrachloride is the preferred sources of the tin because of the availability and cost of the raw material.

It has been found, that, in order to form the tin oxide coating at the optimum deposition rates, it is desirable to use an organic oxygen containing compound which is an ester, particularly an ester in which the group derived from the alcohol is an alkyl group with a β hydrogen. Additionally, the decomposition temperature of the ester should not be greater than the reaction temperature of the coating precursor gas mixture at the desired point of application. Esters utilized in the precursor gas mixture that have a β hydrogen and appropriate decomposition temperatures will deposit the coatings at high deposition rates. The preferred group of esters used in practicing the present invention includes the group consisting of ethyl formate, ethyl acetate, ethyl propionate, isopropyl formate, isopropyl acetate, n-butyl acetate, and t-butyl acetate.

In general an ester decomposes in a continuous fashion over a given temperature range. In the present invention, the thermal decomposition temperature of the ester is defined as the temperature at which the unimolecular decomposition rate constant of the ester is 0.01/sec. The unimolecular decomposition rate constants of common esters such as ethyl acetate and t-butyl acetate are well known and can be found in the chemical literature. For ethyl acetate and t-butyl acetate, the thermal decomposition temperatures using the above definition are 500°C and 344°C (935 and 650° Fahrenheit), and respectively. One skilled in the art will recognize that the choice of ester and specific deposition temperature employed will determine the optimum coating growth rate. Reaction temperatures below the defined thermal decomposition temperature, but within the decomposition range of the selected ester, will result in lower coating growth rates.

In accordance with the present invention, the alkyl group of an ester used in the coating precursor gas mixture may be a carbon compound having a range of 2-10 carbon atoms. The lower limit of the range is dictated by the β hydrogen requirement on the alkyl group. The upper limit is to avoid flammability and volatility issues that arise when the alkyl group contains more than ten carbon atoms.

In practising the method of the present invention, a manifold may be used to connect and regulate the individual gas streams to formulate the coating precursor gas mixture. A common delivery line may be used to deliver the precursor gas mixture from the manifold to the gas beam distributor. An in line static mixer may be used in the delivery line to ensure a homogeneous gas mixture. Additionally, the baffles in the gas distributor beam, illustrated in Fig. 3, or a gas flow restrictor as described with reference to Figure 4, may provide further mixing of the precursor gas at the reactor stage.

In many of the Examples, oxygen was included in the coating precursor gas mixture. However, the deposition rate of the metal oxide coating was not sensitive to the oxygen concentrations, and no oxygen gas was used in Example 7 showing the inclusion of oxygen to be unnecessary

The concentration of the reactive components of the coating precursor gas mixture may be selected to obtain the optimum coating growth rate. The concentration of tin tetrachloride is generally 0.1 to 5.0 percent by volume in the precursor gas mixture. The concentration of tin tetrachloride is based upon the amount of tin needed to provide the desired coating thickness in the available residence time. Thus the tin tetrachloride concentration is adjusted according to process variables, such as the line speed of the ribbon in a float glass process.

The concentration of the organic oxygen compound in the coating precursor gas mixture is generally one to five times the concentration of the tin tetrachloride, being selected within this range based upon the deposition temperature. When using an ester, lower deposition temperatures will result in slower ester decomposition rates and therefore, will require greater concentrations of the ester to react with the tin tetrachloride. Concentrations above or below the optimum range will produce tin oxide coatings at lower coating growth rates.

The temperature of the precursor gas mixture is critical for control of the reaction, in particular to avoid undesirable pre-reaction or adduct formation resulting in formation of an involatile product in the precursor lines. In one preferred embodiment, especially applicable when using an ester, the temperature is maintained above 150°C (300°F) in the precursor gas lines. The precursor gas mixture is also preferably kept below the thermal decomposition temperature of the organic oxygen compound to prevent prereaction of the mixture.

The present inventive process utilizes the heat from the substrate to initialize the coating reaction. In on-line situations, such as the float glass process, the substrate is formed at extremely high temperatures. Therefore, the method of the present invention may be applied at a point in the float glass process where the substrate temperature is lowered but is still above the temperature at which the coating is formed (and preferably after the glass ribbon has substantially finished stretching i.e. below 750°C (1380°F). Off-line applications of the present invention will require heating the substrate to a temperature above the decomposition temperature of the ester.

In practising the method of the present invention in the float glass process, the preferred point of application is in the float bath section. The temperature range at the point of application for the coating is usually about 590°-715°C (1100°-1320°F). The temperature is an important operating parameter because it influences the concentration of the organic compound utilized in the precursor gas mixture. The temperatures of the substrate in the float bath section are relatively stable and therefore exhibit little variation at the point of application.

The heat from the substrate raises the temperature of the precursor gas mixture above the temperature required for coating formation (and when an ester is used as the organic compound above thermal decomposition temperature of the ester). The tin oxide deposition reaction may be initiated by the decomposition of the organic oxygen compound. In the on-line application with a float glass ribbon process, the ribbon passes under the gas distributor beam at a relatively fast rate. The tin oxide coating is deposited onto the float glass ribbon as the ribbon passes under the coater.

The inventors propose the following theory regarding the chemical reaction that may take place when using an ester having an alkyl group with a β hydrogen. However, the inventors do not wish to limit the invention to just this possible explanation, and therefore offer it merely as an aid to understanding the results of the present inventive process.

The inventors propose that as the ester decomposes, the carbon-hydrogen bond on one of the β hydrogens breaks and the hydrogen transfers to the carbonyl group eliminating an alkene and forming a caboxylic acid. The hydrolysis reaction simultaneously takes place between the carboxylic acid and the tin tetrachloride leading to the formation of the tin oxide coating on the substrate.

In general, the resulting article produced in accordance with the present invention comprises a substrate having a tin oxide coating. The coating may be applied directly to the substrate or as a layer in a plurality of coatings on a substrate. The rate of deposition of the tin oxide coating is effected by the decomposition rate of the organic oxygen compound. At constant reaction temperatures different organic oxygen compounds will provide different coating growth rates because of the difference in the decomposition temperatures. Therefore, the desired tin oxide coating growth rate for a given system is selected by matching a specific organic oxygen compound to the precursor gas mixture temperature and the substrate temperature at the point of application.

The present inventive process permits deposition rates over 13nm (130Å) per second with some deposition rates measured well over 30nm (300Å) per second.

A further advantage of the invention, in addition to the high coating rates achievable, is that it employes low cost tin precursor compounds and, especially when the precursor gas mixture is directed over the substrate under the preferred laminar flow conditions, it enables high conversion efficiency (of the tin tetrachloride) to be achieved.

In the present invention, the resulting oxide coating contains little residual carbon from the decomposition of the organic oxygen compound, especially when an ester is used. Carbon is an undesirable byproduct of the coating reaction because high levels of carbon in deposition coatings create absorption problems with the coating. The concern in using an organic oxygen compound in the coating precursor gas mixture is that decomposition will result in levels of carbon that adversely affect the absorption properties of the finished glass. The carbon content in the coatings produced from the method of the present invention showed less than four atomic percent of carbon where measured. This low level of carbon will not significantly affect absorption properties of the coating.

It is to be understood that the forms of the invention herewith shown and described are to be taken as illustrative embodiments only of the same, and that various changes in the shape, size and arrangement of parts, as well as various procedural changes, may be resorted to without departing from the invention, as defined in the claims.

## Claims

1. A process for depositing a tin oxide coating on hot flat glass which is **characterised in that** it comprises the steps of:
(a) preparing a precursor gas mixture containing tin tetrachloride and an organic oxygen containing compound as a source of oxygen for formation of tin oxide,
(b) maintaining said precursor gas mixture at a temperature below the temperature at which the tin tetrachloride reacts to form the tin oxide and below the thermal decomposition temperature of the organic oxygen compound while delivering the mixture to a coating chamber opening on to the hot glass,
(c) introducing the precursor gas mixture into the coating chamber whereby the mixture is heated to cause deposition of the tin oxide incorporating oxygen from the organic compound on the hot glass surface.

2. A process for depositing a tin oxide coating on hot flat glass as claimed in claim 1, wherein said organic oxygen containing compound is an ester.

3. A process for depositing a tin oxide coating on hot flat glass as claimed in claim 2, wherein said ester is an ester having an alkyl group with a β hydrogen.

4. A process for depositing a tin oxide coating on hot flat glass as claimed in any of the preceding claims, wherein said ester is selected from the group consisting of ethyl formate, ethyl acetate, ethyl propionate, isopropyl formate, isopropyl acetate, n-butyl acetate, and t-butyl acetate.

5. A process for depositing a tin oxide coating on hot flat glass as claimed in any of the preceding claims, wherein the substrate is a float glass ribbon having a temperature in the range of abou 590°C-715°C (1100°-1320°F).

6. A process for depositing a tin oxide coating as claimed in any of the preceding claims, wherein the tin tetrachloride in the precursor gas mixture is at a concentration of about 0.1-5.0% by volume.

7. A process for depositing a tin oxide coating on hot flat glass as claimed in any of the preceding claims, wherein the organic oxygen containing compound in the precursor gas mixture is at a concentration of about 1 to 5 times the concentration of the tin tetrachloride.

8. A process for depositing a tin oxide coating on hot flat glass as claimed in any of claims 2 to 7, wherein said ester is ethyl acetate and said hot flat glass is a float glass ribbon.

9. A process for depositing a tin oxide coating on hot flat glass as claimed in any of the preceding claims wherein the hot flat glass substrate has a silica coating thereon, and said tin oxide coating is deposited over the silica coating.

10. A process for depositing a tin oxide coating on hot flat glass as claimed in any of the claims preceding, wherein the hot flat glass substrate has a silica coating over a silicon coating, and said tin oxide coating is deposited over the silica coating.

11. A process for depositing a tin oxide coating on hot flat glass as claimed in any of the preceding claims, wherein the tin oxide coating has a residual carbon content less than 4 atomic percent.

12. A process for depositing a tin oxide coating on hot flat glass as claimed in any of the preceding claims, wherein said precursor gas mixture includes helium as a carrier gas.

13. A process for depositing a tin oxide coating on hot flat glass as claimed in any of claims 2 to 12, wherein the ester has an alkyl group having 2-10 carbon atoms.

14. A process for depositing a tin oxide coating on hot flat glass as claimed in any of the preceding claims, wherein the tin oxide film is deposited at a rate of at least 13nm per second (130Å per second).

15. A process according to any of claims 2 to 14 **characterised in that** the glass substrate is at a temperature above the thermal decomposition temperature of the ester.

16. A process according to any of the preceding claims wherein the precursor gas mixture is caused to flow over the glass surface to be coated under laminar flow conditions.

17. Use of an ester as a source of oxygen for formation of a tin oxide in a process for depositing a tin oxide coating on hot flat glass comprising the steps of :
(a) preparing a precursor gas mixture containing tin tetrachloride and a source of oxygen
(b) maintaining said precursor gas mixture at a temperature below the temperature at which tin tetrachloride reacts to form the metal oxide while delivering the mixture to a coating chamber opening on to the hot glass,
(c) introducing the precursor gas mixture into the coating chamber whereby the mixture is heated to cause deposition of tin oxide on the hot glass.

18. A process for depositing a tin oxide coating on hot flat glass according to any of claims 1 to 16, wherein the precursor gas mixture includes a fluorine containing compound such that the tin oxide coating produced is doped with fluorine.

19. A process for depositing a tin oxide coating on hot flat glass as claimed in claim 18 wherein the fluorine containing compound is hydrogen fluoride.

## Revendications

1. Procédé de dépôt d'un revêtement d'oxyde d'étain sur du verre plat chaud, **caractérisé en ce qu'**il comprend les étapes consistant à :
(a) préparer un mélange gazeux précurseur contenant du tétrachlorure d'étain et un composé organique contenant de l'oxygène comme source d'oxygène pour la formation d'oxyde d'étain,
(b) maintenir ledit mélange gazeux précurseur à une température située au-dessous de la température à laquelle le tétrachlorure d'étain réagit pour former l'oxyde d'étain et au-dessous de la température de décomposition thermique du composé organique contenant de l'oxygène tout en amenant le mélange dans une chambre de revêtement débouchant sur le verre chaud,
(c) introduire le mélange gazeux précurseur dans la chambre de revêtement, moyennant quoi le mélange est chauffé, provoquant le dépôt de l'oxyde d'étain renfermant de l'oxygène provenant du composé organique sur la surface du verre chaud.

2. Procédé de dépôt d'un revêtement d'oxyde d'étain sur du verre plat chaud selon la revendication 1, dans lequel ledit composé organique contenant de l'oxygène est un ester.

3. Procédé de dépôt d'un revêtement d'oxyde d'étain sur du verre plat chaud selon la revendication 2, dans lequel ledit ester est un ester ayant un groupe alkyle avec un atome d'hydrogène β.

4. Procédé de dépôt d'un revêtement d'oxyde d'étain sur du verre plat chaud selon l'une quelconque des revendications précédentes, dans lequel ledit ester est choisi dans le groupe constitué des formiate d'éthyle, acétate d'éthyle, propionate d'éthyle, formiate d'isopropyle, acétate d'isopropyle, acétate de n-butyle et acétate de t-butyle.

5. Procédé de dépôt d'un revêtement d'oxyde d'étain sur du verre plat chaud selon l'une quelconque des revendications précédentes, dans lequel le substrat est un ruban de verre flotté ayant une température dans la plage d'environ 590°C à 715°C (1100-1320°F).

6. Procédé de dépôt d'un revêtement d'oxyde d'étain selon l'une quelconque des revendications précédentes, dans lequel le tétrachlorure d'étain dans le mélange gazeux précurseur est à une concentration d'environ 0,1-5,0 % en volume.

7. Procédé de dépôt d'un revêtement d'oxyde d'étain sur du verre plat chaud selon l'une quelconque des revendications précédentes, dans lequel le composé organique contenant de l'oxygène dans le mélange gazeux précurseur est à une concentration d'environ 1 à 5 fois la concentration de tétrachlorure d'étain.

8. Procédé de dépôt d'un revêtement d'oxyde d'étain sur du verre plat chaud selon l'une quelconque des revendications 2 à 7, dans lequel ledit ester est de l'acétate d'éthyle et ledit verre plat chaud est un ruban de verre flotté.

9. Procédé de dépôt d'un revêtement d'oxyde d'étain sur du verre plat chaud selon l'une quelconque des revendications précédentes, dans lequel le substrat formé de verre plat chaud a un revêtement de silice à sa surface, et ledit revêtement d'oxyde d'étain est déposé par-dessus le revêtement de silice.

10. Procédé de dépôt d'un revêtement d'oxyde d'étain sur du verre plat chaud selon l'une quelconque des revendications précédentes, dans lequel le substrat formé de verre plat chaud a un revêtement de silice par-dessus un revêtement de silicium, et ledit revêtement d'oxyde d'étain est déposé par-dessus le revêtement de silice.

11. Procédé de dépôt d'un revêtement d'oxyde d'étain sur du verre plat chaud selon l'une quelconque des revendications précédentes, dans lequel le revêtement d'oxyde d'étain a une teneur résiduelle en carbone inférieure à 4 % en atomes.

12. Procédé de dépôt d'un revêtement d'oxyde d'étain sur du verre plat chaud selon l'une quelconque des revendications précédentes, dans lequel ledit mélange gazeux précurseur comprend de l'hélium comme gaz porteur.

13. Procédé de dépôt d'un revêtement d'oxyde d'étain sur du verre plat chaud selon l'une quelconque des revendications 2 à 12, dans lequel l'ester a un groupe alkyle ayant de 2 à 10 atomes de carbone.

14. Procédé de dépôt d'un revêtement d'oxyde d'étain sur du verre plat chaud selon l'une quelconque des revendications précédentes, dans lequel le film d'oxyde d'étain est déposé à une vitesse d'au moins 13 nm par seconde (130 Å par seconde).

15. Procédé selon l'une quelconque des revendications 2 à 14, **caractérisé en ce que** le substrat en verre est à une température supérieure à la température de décomposition thermique de l'ester.

16. Procédé selon l'une quelconque des revendications précédentes, dans lequel on oblige le mélange gazeux précurseur à s'écouler sur la surface du verre à revêtir dans des conditions d'écoulement laminaire.

17. Utilisation d'un ester comme source d'oxygène pour la formation d'un oxyde d'étain dans un procédé de dépôt d'un revêtement d'oxyde d'étain sur du verre plat chaud, comprenant les étapes consistant à :
(a) préparer un mélange gazeux précurseur contenant du tétrachlorure d'étain et une source d'oxygène,
(b) maintenir ledit mélange gazeux précurseur à une température située au-dessous de la température à laquelle le tétrachlorure d'étain réagit pour former l'oxyde de métal tout en amenant le mélange dans une chambre de revêtement débouchant sur le verre chaud,
(c) introduire le mélange gazeux précurseur dans la chambre de revêtement, moyennant quoi le mélange est chauffé, provoquant le dépôt d'oxyde d'étain sur le verre chaud.

18. Procédé de dépôt d'un revêtement d'oxyde d'étain sur du verre plat chaud selon l'une quelconque des revendications 1 à 16, dans lequel le mélange gazeux précurseur comprend un composé contenant du fluor, de sorte que le revêtement d'oxyde d'étain produit est dopé avec du fluor.

19. Procédé de dépôt d'un revêtement d'oxyde d'étain sur du verre plat chaud selon la revendication 18, dans lequel le composé contenant du fluor est du fluorure d'hydrogène.

## Patentansprüche

1. Verfahren zum Aufbringen einer Zinnoxidbeschichtung auf heißes Flachglas, **dadurch gekennzeichnet, dass** es die Stufen:
a) Herstellen eines Vorläufergasgemischs, das Zinntetrachlorid und eine Sauerstoff enthaltende organische Verbindung als Sauerstoffquelle für die Bildung des Zinnoxids enthält,
b) Halten des Vorläufergasgemischs auf einer Temperatur von unterhalb der Temperatur, bei welcher das Zinntetrachlorid reagiert, um das Zinnoxid zu bilden, und unterhalb der thermischen Zersetzungstemperatur der organischen Sauerstoffverbindung, während das Gemisch einer Beschichtungskammer zugeleitet wird, die sich zu dem heißen Glas öffnet, und
c) Leiten des Vorläufergasgemischs in die Beschichtungskammer, wodurch das Gemisch erhitzt wird, wobei Zinnoxid, das Sauerstoff aus der organischen Verbindung enthält, auf der heißen Glasoberfläche abgeschieden wird,
umfasst.

2. Verfahren zum Aufbringen einer Zinnoxidbeschichtung auf heißes Flachglas nach Anspruch 1, worin die Sauerstoff enthaltende organische Verbindung ein Ester ist.

3. Verfahren zum Aufbringen einer Zinnoxidbeschichtung auf heißes Flachglas nach Anspruch 2, worin der Ester ein Ester mit einer Alkylgruppe mit einem β-Wasserstoff ist.

4. Verfahren zum Aufbringen einer Zinnoxidbeschichtung auf heißes Flachglas nach einem der vorhergehenden Ansprüche, worin der Ester aus der Gruppe ausgewählt wird, die aus Ethylformiat, Ethylacetat, Ethylpropionat, Isopropylformiat, Isopropylacetat, n-Butylacetat und *tert*.-Butylacetat besteht.

5. Verfahren zum Aufbringen einer Zinnoxidbeschichtung auf heißes Flachglas nach einem der vorhergehenden Ansprüche, worin das Substrat ein Floatglasband mit einer Temperatur im Bereich von etwa 590 bis 715 °C (1100 bis 1320 °F) ist.

6. Verfahren zum Aufbringen einer Zinnoxidbeschichtung nach einem der vorhergehenden Ansprüche, worin das Zinntetrachlorid in dem Vorläufergasgemisch mit einer Konzentration von etwa 0,1 bis 5,0 Vol.-% vorliegt.

7. Verfahren zum Aufbringen einer Zinnoxidbeschichtung auf heißes Flachglas nach einem der vorhergehenden Ansprüche, worin die Sauerstoff enthaltende organische Verbindung im Vorläufergasgemisch mit einer Konzentration von etwa dem 1- bis 5fachen der Konzentration des Zinntetrachlorids vorliegt.

8. Verfahren zum Aufbringen einer Zinnoxidbeschichtung auf heißes Flachglas nach einem der Ansprüche 2 bis 7, worin der Ester Ethylacetat und das heiße Flachglas ein Floatglasband ist.

9. Verfahren zum Aufbringen einer Zinnoxidbeschichtung auf heißes Flachglas nach einem der vorhergehenden Ansprüche, worin das heiße Flachglassubstrat eine Siliciumdioxidbeschichtung besitzt und die Zinnoxidbeschichtung auf der Siliciumdioxidbeschichtung aufgebracht wird.

10. Verfahren zum Aufbringen einer Zinnoxidbeschichtung auf heißes Flachglas nach einem der vorhergehenden Ansprüche, worin das heiße Flachglassubstrat eine Siliciumdioxidbeschichtung auf einer Siliciumbeschichtung besitzt und die Zinnoxidbeschichtung auf der Siliciumdioxidbeschichtung aufgebracht wird.

11. Verfahren zum Aufbringen einer Zinnoxidbeschichtung auf heißes Flachglas nach einem der vorhergehenden Ansprüche, worin die Zinnoxidbeschichtung einen Restkohlenstoffgehalt besitzt, der weniger als 4 Atom-% beträgt.

12. Verfahren zum Aufbringen einer Zinnoxidbeschichtung auf heißes Flachglas nach einem der vorhergehenden Ansprüche, worin das Vorläufergasgemisch Helium als Trägergas enthält.

13. Verfahren zum Aufbringen einer Zinnoxidbeschichtung auf heißes Flachglas nach einem der Ansprüche 2 bis 12, worin der Ester eine Alkylgruppe mit 2 bis 10 Kohlenstoffatomen besitzt.

14. Verfahren zum Aufbringen einer Zinnoxidbeschichtung auf heißes Flachglas nach einem der vorhergehenden Ansprüche, worin die Zinnoxidschicht mit einer Geschwindigkeit von mindestens 13 nm pro Sekunde (130 Å pro Sekunde) aufgebracht wird.

15. Verfahren nach einem der Ansprüche 2 bis 14, **dadurch gekennzeichnet, dass** sich die Temperatur des Glassubstrats auf über der thermischen Zersetzungstemperatur des Esters befindet.

16. Verfahren nach einem der vorhergehenden Ansprüche, worin das Vorläufergasgemisch über die zu beschichtende Glasoberfläche unter laminaren Strömungsbedingungen strömen gelassen wird.

17. Verwendung eines Esters als Sauerstoffquelle für die Bildung eines Zinnoxids in einem Verfahren zum Aufbringen einer Zinnoxidbeschichtung auf heißes Flachglas, welche die Stufen:
a) Herstellen eines Vorläufergasgemischs, das Zinntetrachlorid und eine Sauerstoffquelle enthält,
b) Halten des Vorläufergasgemischs auf einer Temperatur von unterhalb der Temperatur, bei welcher Zinntetrachlorid reagiert und das Metalloxid bildet, während das Gemisch in eine Beschichtungskammer geleitet wird, die sich zum heißen Glas hin öffnet, und
c) Leiten des Vorläufergasgemischs in die Beschichtungskammer, wodurch das Gemisch erhitzt wird, um das Abscheiden des Zinnoxids auf dem heißen Glas zu bewirken,
umfasst.

18. Verfahren zum Aufbringen einer Zinnoxidbeschichtung auf heißes Flachglas nach einem der Ansprüche 1 bis 16, worin das Vorläufergasgemisch derart eine Fluor enthaltende Verbindung enthält, dass die erzeugte Zinnoxidbeschichtung mit Fluor dotiert ist.

19. Verfahren zum Aufbringen einer Zinnoxidbeschichtung auf heißes Flachglas nach Anspruch 18, worin die Fluor enthaltende Verbindung Fluorwasserstoff ist.
